# EUROPEAN PATENT APPLICATION

(11) **EP 4 765 566 A1**
(43) Date of publication of application: **24.06.2026**
(21) Application number: 25837539.3
(22) Date of filing: 12.06.2025
(51) Int. Cl.: H02J 7/00, H01M 10/44, H05K 7/20

(54) **BATTERY CHARGING DEVICE AND BATTERY FORMATION SYSTEM INCLUDING SAME**

(30) Priority: 09.07.2024 KR 20240090752
(71) Applicant: LG Energy Solution, Ltd., Seoul 07335 (KR)
(72) Inventor: KIM, Seung-Choo, Daejeon 34122 (KR); KIM, Myung-Hwan, Daejeon 34122 (KR); RYU, Je-Chang, Daejeon 34122 (KR)
(74) Representative: Goddar, Heinz J.
(86) International application number: PCT/KR2025/008098
(87) International publication number: WO 2026/014734

(57) **Abstract**

A battery charging apparatus according to the present disclosure includes a current supply circuit configured to supply charging current through a plurality of conducting wires that each corresponds to respective one of the plurality of batteries; and a charging jig configured to support the plurality of batteries and provide the charging current supplied through the plurality of conducting wires to the plurality of batteries, wherein the charging jig includes a plurality of connection pins electrically connecting the plurality of conducting wires to the first electrode terminals of the plurality of batteries; a conductive plate that is in common contact with the second electrode terminals of the plurality of batteries to allow the second electrode terminals to have the same potential; and a cooling structure having a cooling channel through which a cooling material moves and configured to cool the conductive plate.

## Description

### TECHNICAL FIELD

This application is based on and claims priority from Korean Patent Application No. 10-2024-0090752, filed on July 9, 2024, with the Korean Intellectual Property Office, the disclosure of which is incorporated herein in its entirety by reference.

The present disclosure relates to a battery charging apparatus and a battery formation system including the same, and more specifically, to a battery charging apparatus for charging a plurality of rechargeable batteries, and a battery formation system for activating a manufactured battery using such a battery charging apparatus.

### BACKGROUND ART

In general, a secondary battery refers to a battery that can be repeatedly charged and discharged, such as a lithium-ion battery, a lithium polymer battery, a nickel cadmium battery, a nickel hydrogen battery, a nickel zinc battery, and the like.

Recently, as batteries are applied not only to small devices such as mobile phones, tablet PCs, and laptops, but also to large devices requiring high output voltage and large charging capacities, such as electric vehicles and energy storage systems (ESSs), interest in and demand for battery manufacturing technologies that can improve manufacturing efficiency and process safety are increasing.

Meanwhile, the battery manufacturing process includes an electrode process, an assembly process, a formation process, and the like. The electrode process is a process of manufacturing positive electrodes and negative electrodes applied to the battery. The assembly process is a process of placing an electrode assembly in which a positive electrode and a negative electrode are laminated with a separator therebetween, and an electrolyte material into a case, and then sealing the case. The formation process is a process of repeatedly charging and discharging the assembled battery to activate it, and then performing aging of the activated battery. Among these various processes, the formation process uses a charger to charge the assembled battery.

However, existing technology uses a charger with a complex electrical connection structure to charge a plurality of batteries simultaneously, thereby requiring significant costs for charger manufacturing, and causing a problem of being difficult to place a cooling structure for cooling the electrical connection structure of the charger inside the charger.

As a result, existing technology reduces the internal temperature of the charger using a blower fan, which lowers cooling efficiency and cannot prevent overheating of the connection member that actually generates the most heat by directly contacting the electrode terminal of the battery to be charged.

### DISCLOSURE

### Technical Problem

The present disclosure is directed to providing a battery charging apparatus that may simplify an electrical connection structure, reduce manufacturing costs, and facilitate the arrangement of a cooling structure, and a battery formation system including such a battery charging apparatus.

Additionally, the present disclosure is directed to providing a battery charging apparatus that may prevent overheating of a connection member in direct contact with the electrode terminal of a battery to be charged and improve the safety of the battery charging process, and a battery formation system including such a battery charging apparatus.

Furthermore, those having ordinary skill in the art to which the present disclosure pertains will clearly understand from the following description that various embodiments according to the present disclosure may solve various technical problems not mentioned above.

### Technical Solution

A battery charging apparatus according to one aspect of the present disclosure is an apparatus for charging a plurality of batteries that each has a first electrode terminal and a second electrode terminal, and the battery charging apparatus includes a current supply circuit configured to supply charging current through a plurality of conducting wires that each corresponds to respective one of the plurality of batteries; and a charging jig configured to support the plurality of batteries and provide the charging current supplied through the plurality of conducting wires to the plurality of batteries, wherein the charging jig includes a plurality of connection pins electrically connecting the plurality of conducting wires to the first electrode terminals of the plurality of batteries; a conductive plate that is in common contact with the second electrode terminals of the plurality of batteries to allow the second electrode terminals to have the same potential; and a cooling structure having a cooling channel through which a cooling material moves and configured to cool the conductive plate.

In an embodiment, the current supply circuit and the conductive plate of the charging jig may be configured to be connected to a common ground.

In an embodiment, the battery charging apparatus may further include an enclosure that accommodates the current supply circuit and the charging jig, and the current supply circuit and the conductive plate may be configured to use the enclosure as the common ground.

In an embodiment, the enclosure may include a conductive layer and an insulating layer that are stacked on each other, and the current supply circuit and the conductive plate may be configured to be connected to the conductive layer of the enclosure.

In an embodiment, the conductive plate may have a first contact surface where the second electrode terminals of the plurality of batteries are in common contact and a second contact surface where the cooling structure is in contact, and the first contact surface may have a plurality of seating grooves where the plurality of batteries are respectively seated.

In an embodiment, the conductive plate may be manufactured from a metal plate, and the plurality of seating grooves may be formed by curving or bending a plurality of portions of the metal plate.

In an embodiment, the battery charging apparatus may further include a fastening member that couples the conductive plate and the cooling structure to each other.

In an embodiment, the conductive plate may have a through hole, and the fastening member may include a fastening rod that has an outer circumferential surface with threads formed thereon and has one end fixed to the cooling structure and the other end passing through the through hole of the conductive plate to be positioned outside the through hole; and a nut screwed to the other end of the fastening rod.

In another embodiment, the conductive plate and the cooling structure may be formed integrally.

In an embodiment, the first electrode terminal may be a positive electrode terminal, and the second electrode terminal may be a negative electrode terminal.

In an embodiment, the battery charging apparatus may further include a chiller configured to provide the cooling material to the cooling channel of the cooling structure and to cool the cooling material discharged from the cooling channel.

A battery formation system according to another aspect of the present disclosure includes the battery charging apparatus described above.

### Advantageous Effects

According to the present disclosure, a charging jig of a battery charging apparatus that charges a plurality of batteries is configured to electrically connect the plurality of batteries to a current supply circuit using a conductive plate in common contact with the electrode terminals of the plurality of batteries, thereby simplifying the electrical connection structure of the battery charging apparatus, reducing manufacturing costs, and facilitating the arrangement of a cooling structure that cools the battery charging apparatus.

Additionally, a cooling structure having a cooling channel through which a cooling material moves is configured to cool the conductive plate, thereby preventing overheating of the conductive plate in direct contact with the electrode terminals of the batteries to be charged, and improving the safety of the battery charging process.

Additionally, the current supply circuit providing the charging current and the conductive plate are configured to use the enclosure of the battery charging apparatus as a common ground, thereby reducing the amount of cables used in the battery charging apparatus, and as a result, heat generated during cable use, line resistance, parasitic reactance, and the like may be reduced, and the charging voltage and charging current may be stabilized.

Furthermore, those having ordinary skill in the art to which the present disclosure pertains will clearly understand from the following description that various embodiments according to the present disclosure may provide various technical advantages not mentioned above.

### DESCRIPTION OF DRAWINGS

FIG. 1 is a block diagram showing a battery charging apparatus according to an embodiment of the present disclosure.
FIG. 2 is a perspective view showing an example of a battery chargeable by the present disclosure.
FIG. 3 is a cross-sectional view of the battery illustrated in FIG. 2.
FIG. 4 is a view schematically showing the electrical connection relation between a current supply circuit and a charging jig of a battery charging apparatus according to an embodiment of the present disclosure.
FIG. 5 is a perspective view showing a state in which a conductive plate and a cooling structure of a battery charging apparatus according to a modified embodiment are coupled to each other.
FIG. 6 is an exploded perspective view showing a state in which the conductive plate and the cooling structure illustrated in FIG. 5 are separated.
FIG. 7 is a perspective view showing a conductive plate and a cooling structure according to another modified embodiment.
FIG. 8 is a view showing the internal structure of a battery charging apparatus according to an embodiment of the present disclosure.
FIG. 9 is an enlarged view showing part A1 of FIG. 8.
FIG. 10 is a block diagram showing a battery formation system according to an embodiment of the present disclosure.

### BEST MODE

Hereinafter, embodiments according to the present disclosure will be described in detail with reference to the accompanying drawings in order to clarify solutions corresponding to the technical problems of the present disclosure. However, if the description of related known technology rather obscures the gist of the present disclosure in describing the present disclosure, the description thereof may be omitted. Additionally, the terms used in this specification are terms defined in consideration of functions in the present disclosure, which may vary depending on the intention or custom of the designer, manufacturer, and the like. Therefore, definitions of terms to be described below should be made based on the content throughout this specification.

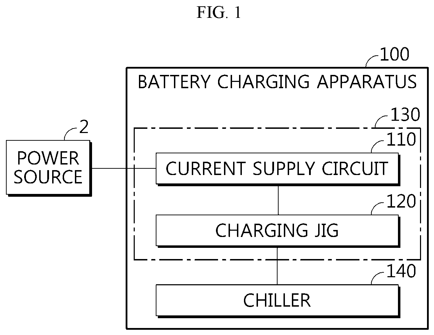

FIG. 1 is a block diagram showing a battery charging apparatus 100 according to an embodiment of the present disclosure.

As illustrated in FIG. 1, the battery charging apparatus 100 according to the present disclosure is configured to receive power from an external power source 2 and charge a plurality of batteries. To this end, the battery charging apparatus 100 includes a current supply circuit 110 and a charging jig 120.

The current supply circuit 110 is configured to supply charging current through a plurality of conducting wires that each corresponds to respective one of the plurality of batteries. For example, the current supply circuit 110 may convert power delivered from the power source 2 to generate charging current and supply the charging current to a charging jig 120 to be described later. To this end, the current supply circuit 110 may include at least one of an AC-DC converter and a DC-DC converter.

The charging jig 120 is configured to support the plurality of batteries and provide the charging current supplied through the plurality of conducting wires to the plurality of batteries.

As will be described again below, the charging jig 120 includes a plurality of connection pins, a conductive plate, and a cooling structure.

The plurality of connection pins are configured to electrically connect a plurality of conducting wires that each corresponds to respective one of the plurality of batteries, to the first electrode terminals of the plurality of batteries.

The conductive plate is configured to be in common contact with the second electrode terminals of the plurality of batteries. The conductive plate in contact with the second electrode terminals allows the second electrode terminals to have the same potential.

The cooling structure has a cooling channel through which a cooling material moves and is configured to cool the conductive plate.

In an embodiment, the battery charging apparatus 100 may further include an enclosure 130 that accommodates the current supply circuit 110 and the charging jig 120. This enclosure 130 may be manufactured from a metal plate.

In an embodiment, the battery charging apparatus 100 may further include a chiller 140 that provides a cooling material to the cooling structure of the charging jig 120, and collects and cools the cooling material discharged from the cooling structure. In this case, the chiller 140 may be disposed outside the enclosure 130. Additionally, the cooling material may be cooling water, or a cooling medium such as hydro-fluoro-olefin (HFO), hydro-fluoro-carbon (HFC), or chloro-fluoro-carbon (CFC).

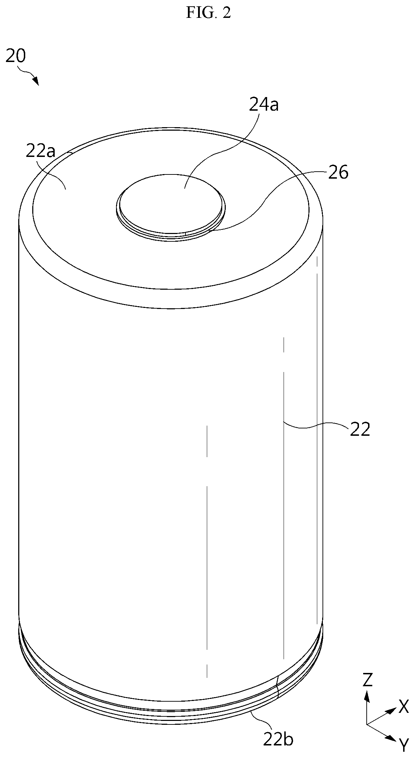

FIG. 2 is a perspective view showing an example of a battery chargeable by the present disclosure.

As illustrated in FIG. 2, the battery charging apparatus 100 according to the present disclosure may charge a battery 20 having a first electrode terminal and a second electrode terminal that are positioned to be spaced apart from each other. The first electrode terminal may be a positive electrode terminal, and the second electrode terminal may be a negative electrode terminal.

A cylindrical battery is illustrated in FIG. 2, but it is obvious that the battery charging apparatus 100 according to the present disclosure may be configured to charge other types of batteries, such as a pouch-type battery and a prismatic battery.

The battery 20 has a cylindrical case 22 forming an outer body. This case 22 has a top surface 22a and a bottom surface 22b, and a rivet 24a that functions as a first electrode terminal may be provided at the center of the top surface 22a. Additionally, an insulation gasket 26 may be provided between the top surface 22a of the case 22 and the rivet 24a.

The bottom surface 22b of the case 22 may be configured to function as a second electrode terminal. In this case, the first electrode terminal may be a positive electrode terminal, and the second electrode terminal may be a negative electrode terminal.

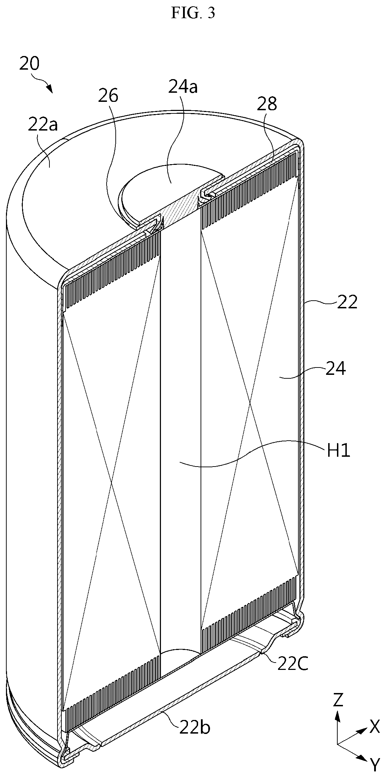

FIG. 3 is a cross-sectional view of the battery 20 illustrated in FIG. 2.

As illustrated in FIG. 3, the case 22 of the battery 20 accommodates an electrode assembly 24 and an electrolyte material. The electrode assembly 24 has a laminated structure in which a positive electrode and a negative electrode are laminated with a separator therebetween. For example, the electrode assembly 24 may have a jelly-roll shape. In this case, a hollow space H1 may be formed at the center of the electrode assembly 24.

Additionally, the bottom surface 22b of the case 22 may have a venting structure 22c configured to discharge gas generated inside the battery 20.

An insulator 28 may be disposed between the upper uncoated portion of the electrode assembly 24 electrically connected to the rivet 24a and the top surface 22a of the case 22.

The battery 20 assembled in this way may be activated by repeating charging and discharging.

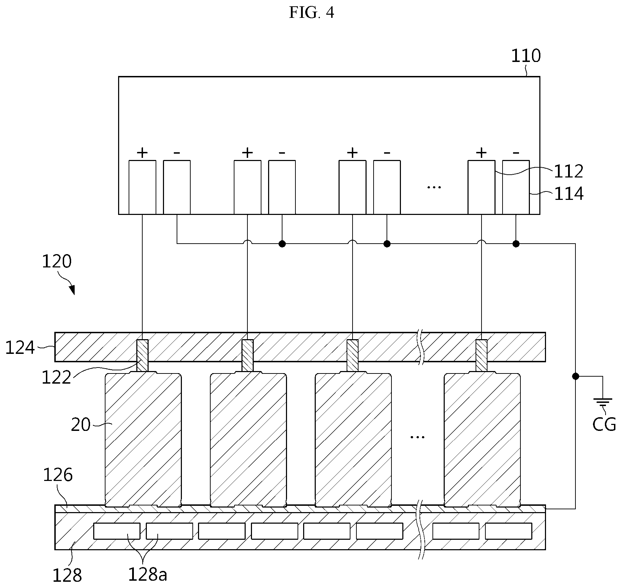

FIG. 4 is a view schematically showing the electrical connection relation between a current supply circuit 110 and a charging jig 120 of a battery charging apparatus according to an embodiment of the present disclosure.

As illustrated in FIG. 4, the current supply circuit 110 is configured to supply charging current through a plurality of conducting wires that each corresponds to respective one of a plurality of batteries 20. To this end, the current supply circuit 110 may include a plurality of terminal pairs 112, 114 that each corresponds to respective one of the plurality of batteries 20. Each terminal pair may include a first circuit terminal 112 corresponding to a first electrode terminal of the corresponding battery, and a second circuit terminal 114 corresponding to a second electrode terminal of the corresponding battery.

This current supply circuit 110 may convert power delivered from the power source 2 to generate charging current and supply the charging current to the charging jig 120.

The charging jig 120 may support the plurality of batteries 20 and provide the charging current supplied through the plurality of conducting wires to the plurality of batteries 20. To this end, the charging jig 120 includes a plurality of connection pins 122, a conductive plate 126, and a cooling structure 128.

The plurality of connection pins 122 are configured to electrically connect the plurality of conducting wires that each corresponds to respective one of the plurality of batteries 20, to the first electrode terminals of the plurality of batteries 20.

In an embodiment, the charging jig 120 may further include a support structure 124 that supports the plurality of connection pins 122. In this case, the support structure 124 may be configured to contact each connection pin 122 with the first electrode terminal of the corresponding battery.

The conductive plate 126 is configured to be in common contact with the second electrode terminals of the plurality of batteries 20. The conductive plate 126 in contact with the second electrode terminals allows the second electrode terminals to have the same potential.

In an embodiment, the first electrode terminal of each battery 20 may be a positive electrode terminal, and the second electrode terminal may be a negative electrode terminal.

The cooling structure 128 has a cooling channel 128a through which a cooling material moves and is configured to cool the conductive plate 126 by contacting the conductive plate 126. The chiller 140 described with reference to FIG. 1 may provide a cooling material to the cooling channel 128a of the cooling structure 128 and cool the cooling material discharged from the cooling channel 128a again.

In an embodiment, the conductive plate 126 and the cooling structure 128 of the charging jig 120 may be formed integrally.

Meanwhile, the current supply circuit 110 and the conductive plate 126 of the charging jig 120 may be configured to be connected to a common ground CG. As will be described again below, the current supply circuit 110 and the conductive plate 126 may be configured to use the above-described enclosure 130 as a common ground.

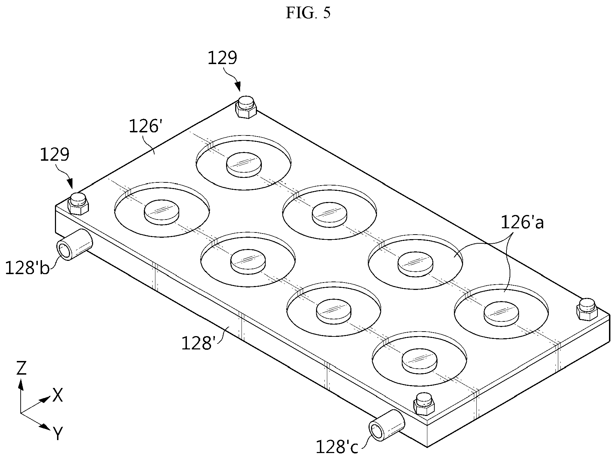

FIG. 5 is a perspective view showing a state in which a conductive plate 126' and a cooling structure 128' of a battery charging apparatus according to a modified embodiment are coupled to each other.

As illustrated in FIG. 5, the conductive plate 126' may have a first contact surface where the second electrode terminals of the plurality of batteries are in common contact. This first contact surface of the conductive plate 126' may have a plurality of seating grooves 126'a where the plurality of batteries are respectively seated.

Additionally, the conductive plate 126' may have a second contact surface where the cooling structure 128' is in contact. The cooling structure 128' may contact the conductive plate 126' to cool the conductive plate 126'.

In this case, the cooling structure 128' may have a plate shape corresponding to the conductive plate 126'. Additionally, as described with reference to FIG. 4, the cooling structure 128' may be provided with a cooling channel therein that provides a moving path for the cooling material. This cooling structure 128' may include an inlet 128'b through which the cooling material is introduced and an outlet 128'c through which the cooling material is discharged.

As described with reference to FIG. 1, the chiller 140 of the battery charging apparatus 100 may inject a cooling material cooled to a predetermined temperature or lower into the inlet 128'b of the cooling structure 128', and may collect the cooling material discharged from the outlet 128'c of the cooling structure 128' and cool the cooling material again.

Meanwhile, the battery charging apparatus 100 may include a fastening member 129 that couples the conductive plate 126' and the cooling structure 128' to each other.

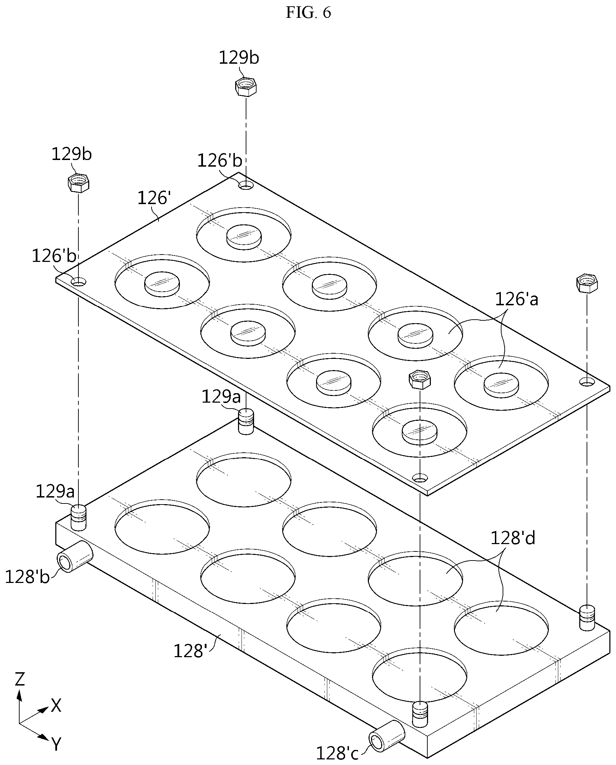

FIG. 6 is an exploded perspective view showing a state in which the conductive plate 126' and the cooling structure 128' illustrated in FIG. 5 are separated.

As illustrated in FIG. 6, the conductive plate 126' may have a plurality of through holes 126'b. Additionally, the fastening member 129 that couples the conductive plate 126' and the cooling structure 128' to each other may include a fastening rod 129a and a nut 129b.

The fastening rod 129a may have an outer circumferential surface with threads formed thereon, and may be configured such that one end thereof is fixed to the cooling structure 128' and the other end thereof passes through the through hole 126'b of the conductive plate 126' to be positioned outside the through hole 126'b, that is, above the through hole 126'b.

The nut 129b may be configured to be screwed to the other end of the fastening rod 129a passing through the through hole 126'b to be positioned above the through hole 126'b.

In an embodiment, the conductive plate 126' may be manufactured from a metal plate. Additionally, the plurality of seating grooves 126'a of the conductive plate 126' may be formed by curving or bending a plurality of portions of the metal plate. For example, the plurality of seating grooves 126'a may be formed through a press process or a deep drawing process.

In this case, a plurality of protrusions each corresponding to the plurality of seating grooves 126'a are formed on the lower surface (second contact surface) of the conductive plate 126', which is opposite to the upper surface (first contact surface) of the conductive plate 126' on which the plurality of seating grooves 126'a are formed. In order to increase the contact area between the conductive plate 126' and the cooling structure 128', a plurality of insertion grooves 128'd where the plurality of protrusions are respectively inserted and fitted may be provided on the upper surface of the cooling structure 128' in contact with the lower surface (second contact surface) of the conductive plate 126'.

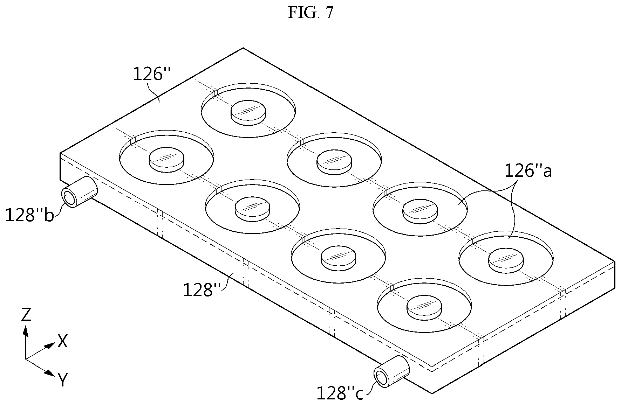

FIG. 7 is a perspective view showing a conductive plate 126" and a cooling structure 128" according to another modified embodiment.

As illustrated in FIG. 7, the conductive plate 126" and the cooling structure 128" may be formed integrally. In this case, a plurality of seating grooves 126"a in which batteries to be charged are seated may be provided on the upper surface of the conductive plate 126".

Additionally, the cooling structure 128" formed integrally with the conductive plate 126" may include an inlet 128"b through which a cooling material is introduced, and an outlet 128"c through which the cooling material moving along the cooling channel provided inside the cooling structure 128" is discharged.

In this way, when the conductive plate 126" and the cooling structure 128" are formed integrally, the fastening member 129 described with reference to FIGS. 5 and 6 is omitted.

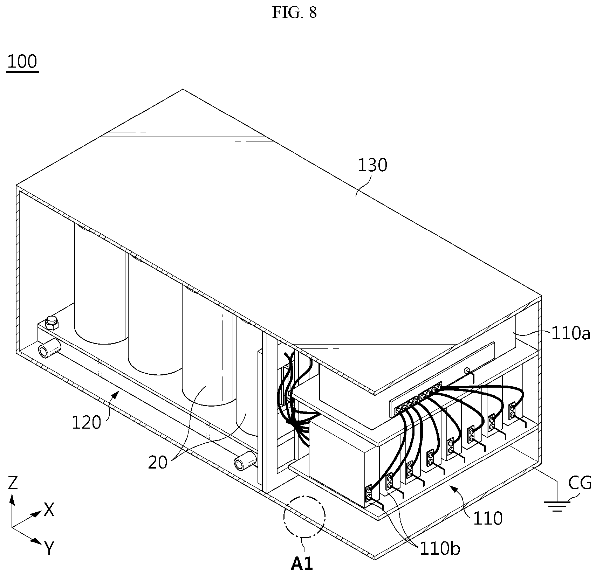

FIG. 8 is a view showing the internal structure of a battery charging apparatus 100 according to an embodiment of the present disclosure.

As illustrated in FIG. 8, the battery charging apparatus 100 according to an embodiment of the present disclosure may further include an enclosure 130 accommodating the current supply circuit 110 and the charging jig 120 described above. This enclosure 130 may be manufactured from a metal plate.

The current supply circuit 110 accommodated inside the enclosure 130 may supply the charging current required to charge a plurality of batteries 20 using power provided from an external power source. To this end, the current supply circuit 110 may include a main circuit 110a and a plurality of channel circuits 110b.

In this case, the main circuit 110a may be configured to primarily convert power provided from the external power source. For example, the main circuit 110a may be configured to rectify and step down power provided from the external power source and deliver it to the plurality of channel circuits 110b. To this end, the main circuit 110a may include at least one of an AC-DC converter and a DC-DC converter.

Additionally, each channel circuit 110b may be configured to secondarily convert power delivered from the main circuit 110a. For example, each channel circuit 110b may be configured to appropriately convert DC power delivered from the main circuit 110a to generate charging current, and to supply this charging current to one or two or more batteries 20. To this end, the channel circuit 110b may include a DC-DC converter.

The current supply circuit 110 is configured to supply the charging current required to charge the plurality of batteries 20 through a plurality of conducting wires that each corresponds to respective one of the plurality of batteries. For example, the current supply circuit 110 may convert power delivered from the power source 2 to generate charging current and supply the charging current to the charging jig 120 to be described later. To this end, the current supply circuit 110 may include at least one of an AC/DC converter and a DC/DC converter.

The charging jig 120 supports the plurality of batteries 20 and is configured to provide the charging current supplied from the current supply circuit 110 to the plurality of batteries 20.

As described above, the current supply circuit 110 and the conductive plates 126, 126', 126" of the charging jig 120 described above may be configured to be connected to a common ground CG. In this case, the current supply circuit 110 and the conductive plates 126, 126', 126" may be configured to use the enclosure 130 as a common ground.

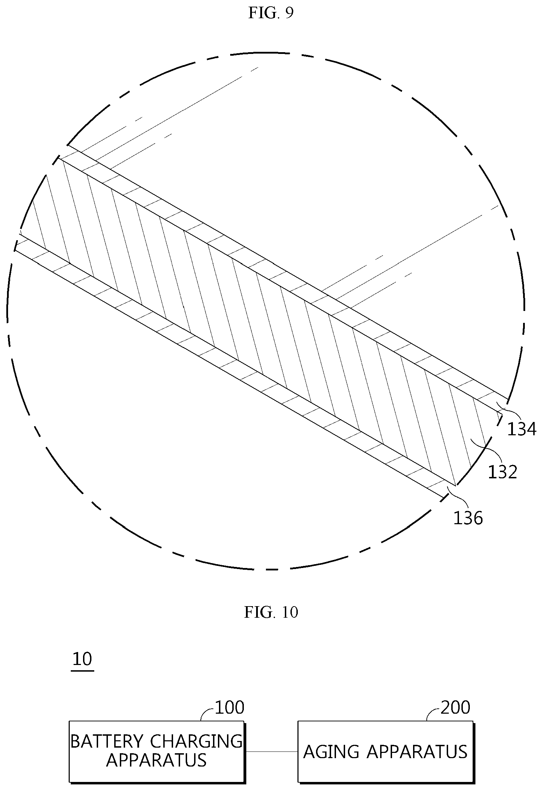

FIG. 9 is an enlarged view showing part A1 of FIG. 8.

As illustrated in FIG. 9, the enclosure 130 may be manufactured from a metal plate coated with an insulating material. As a result, the enclosure 130 may include a conductive layer 132 and insulating layers 134, 136 that are stacked on each other. In this case, the current supply circuit 110 and the conductive plates 126, 126', 126" may be configured to be connected to the conductive layer 132 of the enclosure 130.

FIG. 10 is a block diagram showing a battery formation system 10 according to an embodiment of the present disclosure.

As illustrated in FIG. 10, the battery formation system 10 according to an embodiment of the present disclosure may include the battery charging apparatus 100 described above. This battery formation system 10 may charge batteries using the battery charging apparatus 100 described above, or may activate the batteries by repeating charging and discharging.

In an embodiment, the battery formation system 10 according to the present disclosure may further include an aging apparatus 200. The aging apparatus 200 may be configured to optimize the electrochemical state of the activated batteries by storing them in an environment with a predetermined temperature and/or humidity for a predetermined time. To this end, the aging apparatus 200 may include a chamber for accommodating the batteries and a control device for controlling the temperature and/or humidity of the chamber.

As described above, according to the present disclosure, a charging jig of a battery charging apparatus that charges a plurality of batteries is configured to electrically connect the plurality of batteries to a current supply circuit using a conductive plate in common contact with the electrode terminals of the plurality of batteries, thereby simplifying the electrical connection structure of the battery charging apparatus, reducing manufacturing costs, and facilitating the arrangement of a cooling structure that cools the battery charging apparatus.

Additionally, a cooling structure having a cooling channel through which a cooling material moves is configured to cool the conductive plate, thereby preventing overheating of the conductive plate in direct contact with the electrode terminals of the batteries to be charged, and improving the safety of the battery charging process.

Additionally, the current supply circuit providing the charging current and the conductive plate are configured to use the enclosure of the battery charging apparatus as a common ground, thereby reducing the amount of cables used in the battery charging apparatus, and as a result, heat generated during cable use, line resistance, parasitic reactance, and the like may be reduced, and the charging voltage and charging current may be stabilized.

Furthermore, it is obvious that embodiments according to the present disclosure may solve various other technical problems in addition to those mentioned in this specification in related technical field as well as in the relevant technical field.

The present disclosure has been described hereinabove with reference to specific embodiments. However, it will be clearly understood to those skilled in the art that various modified embodiments may be implemented within the technical scope of the present disclosure. Therefore, the embodiments disclosed above should be considered from an illustrative perspective rather than a limiting perspective. That is, the scope of the true technical idea of the present disclosure is shown in the claims, and all differences within the scope of equivalents should be construed as being included in the present disclosure.

### [Explanation of Reference Signs]

10: Battery formation system
100: Battery charging apparatus
110: Current supply circuit
112: First circuit terminal
114: Second circuit terminal
120: Charging jig
122: Connection pin
124: Support structure
126, 126', 126": Conductive plate
128, 128', 128": Cooling structure
129: Fastening member
130: Enclosure
140: Chiller

## Claims

1. A battery charging apparatus for charging a plurality of batteries that each has a first electrode terminal and a second electrode terminal, the battery charging apparatus comprising:
a current supply circuit configured to supply charging current through a plurality of conducting wires that each corresponds to respective one of the plurality of batteries; and
a charging jig configured to support the plurality of batteries and provide the charging current supplied through the plurality of conducting wires to the plurality of batteries,
wherein the charging jig comprises:
a plurality of connection pins electrically connecting the plurality of conducting wires to the first electrode terminals of the plurality of batteries;
a conductive plate that is in common contact with the second electrode terminals of the plurality of batteries to allow the second electrode terminals to have the same potential; and
a cooling structure having a cooling channel through which a cooling material moves and configured to cool the conductive plate.

2. The battery charging apparatus according to claim 1,
wherein the current supply circuit and the conductive plate of the charging jig are configured to be connected to a common ground.

3. The battery charging apparatus according to claim 2,
wherein the battery charging apparatus further comprises an enclosure that accommodates the current supply circuit and the charging jig, and
wherein the current supply circuit and the conductive plate are configured to use the enclosure as the common ground.

4. The battery charging apparatus according to claim 3,
wherein the enclosure comprises a conductive layer and an insulating layer that are stacked on each other, and
wherein the current supply circuit and the conductive plate are configured to be connected to the conductive layer of the enclosure.

5. The battery charging apparatus according to claim 1,
wherein the conductive plate has a first contact surface where the second electrode terminals of the plurality of batteries are in common contact, and a second contact surface where the cooling structure is in contact, and
wherein the first contact surface has a plurality of seating grooves where the plurality of batteries are respectively seated.

6. The battery charging apparatus according to claim 5,
wherein the conductive plate is manufactured from a metal plate, and
wherein the plurality of seating grooves are formed by curving or bending a plurality of portions of the metal plate.

7. The battery charging apparatus according to claim 1, further comprising:
a fastening member that couples the conductive plate and the cooling structure to each other.

8. The battery charging apparatus according to claim 7,
wherein the conductive plate has a through hole, and
wherein the fastening member comprises:
a fastening rod that has an outer circumferential surface with threads formed thereon and has one end fixed to the cooling structure and the other end passing through the through hole of the conductive plate to be positioned outside the through hole; and
a nut screwed to the other end of the fastening rod.

9. The battery charging apparatus according to claim 1,
wherein the conductive plate and the cooling structure are formed integrally.

10. The battery charging apparatus according to claim 1,
wherein the first electrode terminal is a positive electrode terminal, and
wherein the second electrode terminal is a negative electrode terminal.

11. The battery charging apparatus according to claim 1, further comprising:
a chiller configured to provide the cooling material to the cooling channel of the cooling structure and to cool the cooling material discharged from the cooling channel.

12. A battery formation system including a battery charging apparatus according to any one of claims 1 to 11.
